# EUROPEAN PATENT APPLICATION

(11) **EP 2 730 620 A1**
(43) Date of publication of application: **14.05.2014**
(21) Application number: 12806920.0
(22) Date of filing: 04.07.2012
(51) Int. Cl.: C08L 83/07, C08G 77/12, C08G 77/20, C08L 83/05, H01L 23/29, H01L 23/31, H01L 33/56

(54) **CURABLE SILICON COMPOSITION, CURED PRODUCT THEREOF, AND OPTICAL SEMICONDUCTOR DEVICE**

(30) Priority: 07.07.2011 JP 2011151312
(71) Applicant: Dow Corning Toray Co., Ltd., Tokyo 100-0004 (JP)
(72) Inventor: AMAKO, Masaaki, Ichihara-shi Chiba 299-0108 (JP); OKAWA, Tadashi, Ichihara-shi Chiba 299-0108 (JP); IIMURA, Tomohiro, Ichihara-shi Chiba 299-0108 (JP); NISHIJIMA, Kazuhiro, Ichihara-shi Chiba 299-0108 (JP); ITOH, Maki, Ichihara-shi Chiba 299-0108 (JP); MORITA, Yoshitsugu, Ichihara-shi Chiba 299-0108 (JP)
(74) Representative: Earnshaw, Geoffrey Mark
(86) International application number: PCT/JP2012/067633
(87) International publication number: WO 2013/005858

(57) **Abstract**

A hydrosilylation curable silicone composition that forms a cured product with a high refractive index, high transparency, excellent heat resistance, and excellent flexibility, the hydrosilylation curable silicone composition comprising, as a main component, an organopolysiloxane represented by the following average unit formula:

(R¹₃SiO_{1/2})ₐ (R¹₂SiO_{2/2})_{b} (R²SiO_{3/2})_{c} (SiO_{4/2})_{d}

wherein, R¹ are alkyl groups, alkenyl groups, phenyl groups, or hydrogen atoms; R² is a group recited for R¹, a condensed polycyclic aromatic group, or a group containing a condensed polycyclic aromatic group, provided that at least one of R¹ or R² in a molecule is an alkenyl group or hydrogen atom, and at least one R² in a molecule is a condensed polycyclic aromatic group or a group containing a condensed polycyclic aromatic group; and **a, b, c,** and **d** are numbers satisfying: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1.

## Description

### Technical field

The present invention relates to a curable silicone composition, a cured product thereof, and an optical semiconductor device.

### Background art

Curable silicone compositions are used as sealing agents for LEDs, raw materials for lenses, and the like due to their excellence in transparency and heat resistance. In order to increase the refractive index of a cured product, an aryl group such as a phenyl group and a naphthyl group is typically introduced into an organopolysiloxane serving as a component. For example, organopolysiloxanes having a condensed polycyclic aromatic group such as a naphthyl group, an anthracenyl group, or a phenanthryl group in a T unit, that is, as R in a siloxane represented by the general formula: RSiO_{3/2}, are proposed in Patent Documents 1 to 4.

However, such organopolysiloxanes do not form cured products having high refractive indices, high transparency, and excellent heat resistance when subjected to hydrosilylation reactions.

In addition, an organopolysiloxane having a condensed polycyclic aromatic group such as a naphthyl group, an anthracenyl group, and a phenanthryl group in a D unit, that is, as R in a siloxane represented by the general formula: R²SiO_{2/2}, is proposed in Patent Document 5.

However, such an organopolysiloxane has the problem that the cured product typically becomes hard and brittle as the refractive index of the cured product is increased, and the mechanical characteristics and heat resistance of the cured product are diminished as a result.

### Prior art documents

### Patent documents

Patent Document 1: Japanese Unexamined Patent Application Publication No. 2008-024832A
Patent Document 2: Japanese Unexamined Patent Application Publication No. 2009-203463A
Patent Document 3: Japanese Unexamined Patent Application Publication No. 2009-280666A
Patent Document 4: Japanese Unexamined Patent Application Publication No. 2010-007057A
Patent Document 5: Japanese Unexamined Patent Application Publication No. 2000-235103A

### Summary of the invention

### Technical problem

An object of the present invention is to provide a curable silicone composition that forms a cured product with a high refractive index, high transparency, excellent heat resistance, and excellent flexibility when cured by a hydrosilylation reaction. A further object of the present invention is to provide a cured product with a high refractive index, high transparency, and excellent heat resistance. Another object of the present invention is to provide a highly reliable optical semiconductor device using this curable silicone composition.

### Disclosure of the Invention

The curable silicone composition of the present invention is cured by a hydrosilylation reaction and contains: as a main component, an organopolysiloxane represented by the following average unit formula:

(R¹₃SiO_{1/2})ₐ (R¹₂SiO_{2/2})_{b} (R²SiO_{3/2})_{c} (SiO_{4/2})_{d}

wherein, R¹ are alkyl groups, alkenyl groups, phenyl groups, or hydrogen atoms; R² is a group recited for R¹, a condensed polycyclic aromatic group, or a group containing a condensed polycyclic aromatic group, provided that at least one of R¹ or R² in a molecule is an alkenyl group or hydrogen atom, and at least one R² in a molecule is a condensed polycyclic aromatic group or a group containing a condensed polycyclic aromatic group; and **a, b, c,** and **d** are numbers satisfying: 0.01 ≤ **a** ≤ 0.8, 0 ≤ **b** ≤ 0.5, 0.2 ≤ **c** ≤ 0.9, 0 ≤ d < 0.2, and **a** + **b** + **c** + **d** = 1.

In addition, the cured product of the present invention is obtained by curing the composition described above.

Furthermore, the optical semiconductor device of the present invention is formed by covering or sealing an optical semiconductor element with the composition described above.

### Effects of the Invention

The curable silicone composition of the present invention is characterized by forming a cured product having a high refractive index, high transparency and excellent heat resistance when cured by a hydrosilylation reaction, and especially by forming a cured product having a low water vapor permeability. In addition, the cured product of the present invention is characterized by having a high refractive index, high transparency and excellent heat resistance, and especially by having a low water vapor permeability. Furthermore, the optical semiconductor device of the present invention is characterized by having excellent reliability.

### Brief description of the drawings

FIG. 1 is a cross-sectional drawing of an LED that is an example of an optical semiconductor device of the present invention.
FIG. 2 is a cross-sectional drawing of a lens that is an example of a cured product of the present invention.

### Detailed description of the invention

First, the curable silicone composition of the present invention will be described in detail.

The curable silicone composition of the present invention is cured by a hydrosilylation reaction and contains: as a main component, an organopolysiloxane represented by the following average unit formula:

(R¹₃SiO_{1/2})ₐ (R¹₂SiO_{2/2})_{b} (R²SiO_{3/2})_{c} (SiO_{4/2})_{d}

In the formula, R¹ are alkyl groups, alkenyl groups, phenyl groups or hydrogen atoms. Examples of the alkyl group for R¹ include methyl groups, ethyl groups, propyl groups, and butyl groups. Of these, methyl groups are preferable. Examples of the alkenyl group for R¹ include vinyl groups, allyl groups, and butenyl groups. Of these, vinyl groups are preferable.

In the formula, R² is an alkyl group, an alkenyl group, a phenyl group, a hydrogen atom, or a condensed polycyclic aromatic group or a group containing a condensed polycyclic aromatic group. Examples of the alkyl group for R² include the groups represented by R¹. Examples of the alkenyl group for R² include the groups represented by R¹. Examples of the condensed polycyclic aromatic group for R² include naphthyl groups, anthracenyl groups, phenanthryl groups, pyrenyl groups, and such condensed polycyclic aromatic groups where a hydrogen atom is replaced by an alkyl group such as a methyl group, an ethyl group, and the like; by an alkoxy group such as a methoxy group, an ethoxy group, and the like; or by a halogen atom such as a chlorine atom, a bromine atom, and the like. The condensed polycyclic aromatic groups for R² are preferably naphthyl groups. Examples of the group containing a condensed polycyclic aromatic group for R² include alkyl groups containing a condensed polycyclic aromatic group such as naphthyl ethyl groups, naphthyl propyl groups, anthracenyl ethyl groups, phenanthryl ethyl groups, pyrenyl ethyl groups, and the like; and such groups where a hydrogen atom in the condensed polycyclic aromatic group is replaced by an alkyl group such as a methyl group, an ethyl group, and the like; by an alkoxy group such as a methoxy group, an ethoxy group, and the like; or by a halogen atom such as a chlorine atom, a bromine atom, and the like. The groups containing a condensed polycyclic aromatic group for R² are preferably alkyl groups containing a condensed polycyclic aromatic group, and particularly preferably naphthyl ethyl groups. An organopolysiloxane where R² is an alkyl group containing a condensed polycyclic aromatic group has relatively low viscosity, and this organopolysiloxane is characterized as being able to lower viscosity of the obtained curable silicone composition.

Furthermore, in the formula, at least one of R¹ or R² in a molecule is an alkenyl group or hydrogen atom. Moreover, in the formula, at least one R² in a molecule is a condensed polycyclic aromatic group or a group containing a condensed polycyclic aromatic group. Preferably, at least 50 mol% of R² in a molecule are condensed polycyclic aromatic groups or groups containing a condensed polycyclic aromatic group.

Furthermore, in the formula, **a, b, c,** and **d** are numbers that satisfy: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1. Preferably, **a, b, c,** and **d** are numbers that satisfy: 0.05 ≤ **a** ≤ 0.7, 0 ≤ **b** ≤ 0.4, 0.3 ≤ **c** ≤ 0.9, 0 ≤ **d** < 0.2, and **a** + **b** + **c** + **d** = 1. Particularly preferably, **a, b, c,** and **d** are numbers that satisfy: 0.1 ≤ **a** ≤ 0.6, 0 ≤ **b** ≤ 0.3, 0.4 ≤ **c** ≤ 0.9, 0 ≤ **d** < 0.2, and **a** + **b** + **c** + **d** = 1. If **a** is below the lower limit of the range described above, the obtained organopolysiloxane changes from the liquid state to solid state, and handling and processability declines. On the other hand, transparency of the obtained cured product declines if **a** exceeds the upper limit of the range described above. Furthermore, stickiness of the obtained cured product occurs if **b** exceeds the upper limit of the range described above. Furthermore, the refractive index of the obtained cured product may markedly decline if c is less than the lower limit of the range described above. On the other hand, the cured product becomes excessively rigid and brittle if **c** exceeds the upper limit of the range described above. Furthermore, the cured product becomes extremely rigid and brittle if d exceeds the upper limit of the range described above.

Although this organopolysiloxane is represented by the average unit formula described above, a small amount of the hydroxyl groups or methoxy groups, ethoxy groups, or the like alkoxy groups may be bonded to silicon atoms in the molecule. An organopolysiloxane that contains silicon-bonded hydroxyl groups or silicon-bonded alkoxy groups can improve the adhesive properties of a curable silicone composition that contains this organopolysiloxane, can improve adhesion of a cured product thereof to a substrate, and can improve affinity with other components contained in a curable silicone composition.

The method of preparing this type of organopolysiloxane is exemplified by a method, in the presence of an acid or base, of hydrolysis and condensation reaction of a silane compound (I) represented by the following general formula:

R³SiX₃,

a disiloxane (II) represented by the following general formula:

R⁴₃SiOSiR⁴₃,

and/or a silane compound (III) represented by the following general formula:

R⁴₃SiX.

The above-mentioned silane compound (I) represented by the following general formula:

R³SiX₃

is a raw material used to introduce condensed polycyclic aromatic groups or groups containing a condensed polycyclic aromatic group into the obtained organopolysiloxane. In the formula, R³ is a condensed polycyclic aromatic group or a group containing a condensed polycyclic aromatic group. Examples of the condensed polycyclic aromatic group for R³ include naphthyl groups, anthracenyl groups, phenanthryl groups, pyrenyl groups, and such condensed polycyclic aromatic groups where a hydrogen atom is replaced by an alkyl group such as a methyl group, an ethyl group, and the like; by an alkoxy group such as a methoxy group, an ethoxy group, and the like; or by a halogen atom such as a chlorine atom, a bromine atom, and the like. Of these, naphthyl groups are preferable. Examples of the group containing a condensed polycyclic aromatic group for R³ include alkyl groups containing a condensed polycyclic aromatic group such as naphthyl ethyl groups, naphthyl propyl groups, anthracenyl ethyl groups, phenanthryl ethyl groups, pyrenyl ethyl groups, and the like; and such groups where a hydrogen atom in the condensed polycyclic aromatic group is replaced by an alkyl group such as a methyl group, an ethyl group, and the like; by an alkoxy group such as a methoxy group, an ethoxy group, and the like; or by a halogen atom such as a chlorine atom, a bromine atom, and the like. The groups containing a condensed polycyclic aromatic group for R³ are preferably alkyl groups containing a condensed polycyclic aromatic group, and particularly preferably naphthyl ethyl groups. Furthermore, in the formula, X are alkoxy groups, acyloxy groups, halogen atoms, or hydroxyl groups. Examples of the alkoxy group for X include methoxy groups, ethoxy groups, and propoxy groups. Examples of the acyloxy group for X include acetoxy groups. Examples of the halogen atom for X include chlorine atoms and bromine atoms.

This type of silane compound (I) is exemplified by alkoxysilanes such as naphthyl trimethoxysilane, anthracenyl trimethoxysilane, phenanthryl trimethoxysilane, pyrenyl trimethoxysilane, naphthyl triethoxysilane, anthracenyl triethoxysilane, phenanthryl triethoxysilane, pyrenyl triethoxysilane, naphthylethyl trimethoxysilane, naphthylpropyl trimethoxysilane, anthracenylethyl trimethoxysilane, and the like; acyloxysilanes such as naphthyl triacetoxysilane, anthracenyl triacetoxysilane, phenanthryl triacetoxysilane, pyrenyl triacetoxysilane, and the like; halosilanes such as naphthyl trichlorosilane, anthracenyl trichlorosilane, phenanthryl trichlorosilane, pyrenyl trichlorosilane, and the like; and hydroxy silanes such as naphthyl trihydroxy silane, anthracenyl trihydroxy silane, phenanthryl trihydroxy silane, pyrenyl trihydroxy silane, and the like.

In addition, the above-mentioned disiloxane compound (II) represented by the following general formula:

R⁴₃SiOSiR⁴₃

is a raw material used to introduce M unit siloxanes into the obtained organopolysiloxane. In the formula, R⁴ are alkyl groups, alkenyl groups, or phenyl groups. Examples of the alkyl group for R⁴ include methyl groups, ethyl groups, and propyl groups. Of these, methyl groups are preferable. Examples of the alkenyl group for R⁴ include vinyl groups, allyl groups, and butenyl groups. Of these, vinyl groups are preferable.

This type of disiloxane (II) is exemplified by 1,3-divinyl-tetramethyldisiloxane, 1,3-divinyl-1,3-diphenyl-dimethyldisiloxane, 1-vinyl-pentamethyldisiloxane, 1-vinyl-1,3-diphenyl-trimethyldisiloxane, 1,3-diphenyl-tetramethyldisiloxane, and hexamethyldisiloxane; and this disiloxane (II) is preferably a disiloxane having an alkenyl group.

In addition, the above-mentioned silane compound (III) represented by the following general formula:

R⁴₃SiX

is also a raw material used to introduce M unit siloxanes into the obtained organopolysiloxane. In the formula, R⁴ are synonymous with the groups described above. In the formula, X is synonymous with the groups described above.

This type of silane compound (III) is exemplified by alkoxysilanes such as dimethylvinylmethoxysilane, methylphenylvinylmethoxysilane, diphenylvinylmethoxysilane, dimethylvinylethoxysilane, methylphenylvinylethoxysilane, diphenylvinylethoxysilane, trimethylmethoxysilane, dimethylphenylmethoxysilane, and the like; acyloxysilanes such as dimethylvinylacetoxysilane, methylphenylvinylacetoxysilane, diphenylvinylacetoxysilane, trimethylacetoxysilane, dimethylphenylacetoxysilane, and the like; halosilanes such as dimethylvinyl chlorosilane, methylphenylvinyl chlorosilane, diphenylvinyl chlorosilane, trimethyl chlorosilane, methylphenyl chlorosilane, and the like; and silanols such as dimethylvinylsilanol, methylphenylvinylsilanol, diphenylvinylsilanol, and the like; and this silane compound (III) is preferably a silane compound having an alkenyl group.

In the preparation method described above, as may be required, a silane compound (IV) represented by the following general formula:

R⁴₍₄₋ₙ₎SiXₙ

can be subjected to reaction. In the formula, R⁴ is synonymous with the groups described above. In the formula, X is synonymous with the groups described above. In the formula, n is an integer of from 2 to 4.

This type of silane compound (IV) is exemplified by alkoxysilanes such as trimethylmethoxysilane, trimethylethoxysilane, methyldiphenylmethoxysilane, methyldiphenylethoxysilane, dimethyldimethoxysilane, methylphenyldimethoxysilane, diphenyldimethoxysilane, methyltrimethoxysilane, phenyltrimethoxysilane, tetramethoxysilane, tetraethoxysilane, and the like; acetoxysilanes such as trimethylacetoxysilane, methyldiphenylacetoxysilane, methyldiphenylacetoxysilane, dimethyldiacetoxysilane, methylphenyldiacetoxysilane, diphenyldiacetoxysilane, methyltriacetoxysilane, phenyltriacetoxysilane, tetraacetoxysilane, and the like; halosilanes such as trimethylchlorosilane, methyldiphenylchlorosilane, methyldiphenylchlorosilane, dimethyldichlorosilane, methylphenyldichlorosilane, diphenyldichlorosilane, methyltrichlorosilane, phenyltrichlorosilane, tetrachlorosilane, and the like; and hydroxysilanes such as trimethylsilanol, methyldiphenylsilanol, methyldiphenylsilanol, dimethyldihydroxysilane, methylphenyldihydroxysilane, diphenyldihydroxysilane, methyltrihydroxysilane, phenyltrihydroxysilane, and the like.

Furthermore, in the preparation method, at least one of component (II) to component (IV) used in the reaction needs to have an alkenyl group.

The preparation method is characterized by performing hydrolysis and condensation reaction of the silane compound (I), the disiloxane (II) and/or the silane compound (III), and as may be required, the silane compound (IV), in the presence of an acid or a base. The charged ratio of each of the components is the ratio such that the obtained organopolysiloxane has the average unit formula below:

(R⁴3SiO_{1/2})ₐ (R⁴₂SiO_{2/2})_{b} (R⁵SiO_{3/2})_{c} (SiO_{4/2})_{d}

That is to say, in the formula, R⁴ are synonymous with the groups described above. R⁵ is a group represented by R³ or is a group represented by R⁴. However, at least one of R⁴ or R⁵ in a molecule is an alkenyl group. At least one R⁵ in a molecule is a condensed polycyclic aromatic group or a group containing a condensed polycyclic aromatic group. Furthermore, in the formula, **a, b, c,** and **d** are numbers that satisfy: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1. Preferably, a, **b, c,** and **d** are numbers that satisfy: 0.05 ≤ **a** ≤ 0.7, 0 ≤ **b** ≤ 0.4, 0.3 ≤ **c** ≤ 0.9, 0 ≤ **d** < 0.2, and **a** + **b** + **c** + **d** = 1. Particularly preferably, **a, b, c,** and **d** are numbers that satisfy: 0.1 ≤ **a** ≤ 0.6, 0 ≤ **b** ≤ 0.3, 0.4 ≤ **c** ≤ 0.9, 0 ≤ **d** < 0.2, and **a** + **b** + **c** + **d** = 1.

Acids that may be used are exemplified by hydrochloric acid, acetic acid, formic acid, nitric acid, oxalic acid, sulfuric acid, phosphoric acid, polyphosphoric acid, polycarboxylic acid, trifluoromethane sulfonic acid, and ion exchange resins. Furthermore, the utilized base is exemplified by inorganic bases such as potassium hydroxide, sodium hydroxide, and the like; and organic base compounds such as triethylamine, diethylamine, monoethanolamine, diethanolamine, triethanolamine, ammonia water, tetramethyl ammonium hydroxide, alkoxysilanes having an amino group, aminopropyltrimethoxysilane, and the like.

Furthermore, an organic solvent may be used in the preparation method described above. The utilized organic solvent is exemplified by ethers, ketones, acetates, aromatic or aliphatic hydrocarbons, γ-butyrolactone, or the like; and mixtures of two or more types of such solvents. Preferred organic solvents are exemplified by propylene glycol monomethyl ether, propylene glycol monomethyl ether acetate, propylene glycol monoethyl ether, propylene glycol monopropyl ether, propylene glycol monobutyl ether, propylene glycol mono-t-butyl ether, γ-butyrolactone, toluene, and xylene.

In order to accelerate the hydrolysis and condensation reaction of each of the components in the preparation method, water or a mixed solution of water and alcohol is preferably added. Methanol and ethanol are preferred examples of the alcohol. If an organic solvent is used and this reaction is promoted by heating, the reaction is preferably performed at the reflux temperature of the organic solvent.

Moreover, another preparation method of the organopolysiloxane is characterized by subjecting a silane compound (I) represented by the following general formula:

R³SiX₃,

and a disiloxane compound (V) represented by the following general formula:

R⁶₃SiOSiR⁶₃,

and/or a silane compound (VI) represented by the following general formula:

R⁶₃SiX,

to a hydrolysis/condensation reaction in the presence of an acid.

The above-mentioned silane compound (I) represented by the following general formula:

R³SiX₃

is a raw material used to introduce condensed polycyclic aromatic groups or groups containing a condensed polycyclic aromatic group into the obtained organopolysiloxane. In the formula, R³ is a condensed polycyclic aromatic group or a group containing a condensed polycyclic aromatic group; and examples thereof are the same as the groups described above. Moreover, X are alkoxy groups, acyloxy groups, halogen atoms, or hydroxyl groups; and examples thereof are the same as the groups described above. Examples of such silane compound (I) are the same as the compounds described above.

In addition, the above-mentioned disiloxane (V) represented by the following general formula:

R⁶₃SiOSiR⁶₃

is a raw material used to introduce M unit siloxanes into the obtained organopolysiloxane. In the formula, R⁶ are alkyl groups, phenyl groups or hydrogen atoms. Examples of the alkyl group for R⁶ include methyl groups, ethyl groups, and propyl groups.

This type of disiloxane (V) is exemplified by 1,1,3,3-tetramethyldisiloxane, 1,3-diphenyl-1,3-dimethyldisiloxane, 1,1,3,3,3-pentamethyldisiloxane, 1,3-diphenyl-1,3,3-trimethyldisiloxane, 1,3-diphenyl-tetramethyldisiloxane, and hexamethyldisiloxane; and this disiloxane (V) is preferably a disiloxane having a silicon-bonded hydrogen atom.

In addition, the above-mentioned silane compound (VI) represented by the following general formula:

R⁶₃S iX

is also a raw material used to introduce M unit siloxanes into the obtained organopolysiloxane. In the formula, R⁶ are synonymous with the groups described above. In the formula, X is synonymous with the groups described above.

This type of silane compound (VI) is exemplified by alkoxysilanes such as dimethylmethoxysilane, methylphenylmethoxysilane, diphenylmethoxysilane, dimethylethoxysilane, methylphenylethoxysilane, diphenylethoxysilane, trimethylmethoxysilane, dimethylphenylmethoxysilane, and the like; acyloxysilanes such as dimethylacetoxysilane, methylphenylacetoxysilane, diphenylacetoxysilane, trimethylacetoxysilane, dimethylphenylacetoxysilane, and the like; halosilanes such as dimethylchlorosilane, methylphenylchlorosilane, diphenylchlorosilane, trimethylchlorosilane, methylphenylchlorosilane, and the like; and silanols such as dimethylsilanol, methylphenylsilanol, diphenylsilanol, and the like. The silane compound (VI) is preferably a silane compound having a silicon-bonded hydrogen atom.

In the preparation method described above, as may be required, a silane compound (VII) represented by the following general formula:

R⁶₍₄₋ₙ₎SiXₙ

can be subjected to a reaction. In the formula, R⁶ is synonymous with the groups described above. In the formula, X is synonymous with the groups described above. In the formula, n is an integer of from 2 to 4.

This type of silane compound (VII) is exemplified by alkoxysilanes such as trimethylmethoxysilane, trimethylethoxysilane, methyldiphenylmethoxysilane, methyldiphenylethoxysilane, dimethyldimethoxysilane, methylphenyldimethoxysilane, diphenyldimethoxysilane, methyltrimethoxysilane, phenyltrimethoxysilane, tetramethoxysilane, tetraethoxysilane, and the like; acetoxysilanes such as trimethylacetoxysilane, methyldiphenylacetoxysilane, methyldiphenylacetoxysilane, dimethyldiacetoxysilane, methylphenyldiacetoxysilane, diphenyldiacetoxysilane, methyltriacetoxysilane, phenyltriacetoxysilane, tetraacetoxysilane, and the like; halosilanes such as trimethylchlorosilane, methyldiphenylchlorosilane, methyldiphenylchlorosilane, dimethyldichlorosilane, methylphenyldichlorosilane, diphenyldichlorosilane, methyltrichlorosilane, phenyltrichlorosilane, tetrachlorosilane, and the like; and hydroxysilanes such as trimethylsilanol, methyldiphenylsilanol, methyldiphenylsilanol, dimethyldihydroxysilane, methylphenyldihydroxysilane, diphenyldihydroxysilane, methyltrihydroxysilane, phenyltrihydroxysilane, and the like.

Furthermore, in the preparation method, at least one of component (V) to component (VII) used in the reaction needs to have a silicon-bonded hydrogen atom.

The preparation method is characterized by performing hydrolysis and condensation reaction of the silane compound (I), the disiloxane (V) and/or the silane compound (VI), and as may be required, the silane compound (VII), in the presence of an acid. The charged ratio of each of the components is the ratio such that the obtained organopolysiloxane has the average unit formula below:

(R⁶₃SiO_{1/2}), (R⁶₂SiO_{2/2})_{b} (R⁷SiO_{03/2})_{c} (SiO_{4/2})_{d}.

That is to say, in the formula, R⁶ are groups synonymous with the groups described above. R⁷ is a group represented by R³ or is a group represented by R⁶. However, at least one of R⁶ or R⁷ in a molecule is a hydrogen atom. At least one R⁷ in a molecule is a condensed polycyclic aromatic group or a group containing a condensed polycyclic aromatic group. Furthermore, in the formula, **a, b, c,** and d are numbers that satisfy: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1. Preferably, **a, b, c,** and **d** are numbers that satisfy: 0.05 ≤ **a** ≤ 0.7, 0 ≤ **b** ≤ 0.4, 0.3 ≤ **c** ≤ 0.9, 0 ≤ **d** < 0.2, and **a** + **b** + **c** + **d** = 1. Particularly preferably, **a, b, c,** and **d** are numbers that satisfy: 0.1 ≤ **a** ≤ 0.6, 0 ≤ **b** ≤ 0.3, 0.4 ≤ **c** ≤ 0.9, 0 ≤ **d** < 0.2, and **a** + **b** + **c** + **d** = 1.

Acids that may be used are exemplified by strong acids such as hydrochloric acid, nitric acid, sulfuric acid, phosphoric acid, polyphosphoric acid, trifluoromethane sulfonic acid, and the like; carboxylic acids such as acetic acid, formic acid, oxalic acid, polycarboxylic acid, and the like, and carboxylic acid anhydrides such as acetic acid anhydride and the like.

Furthermore, an organic solvent may be used in the preparation method described above. Examples of the utilized organic solvent are the same as the solvents described above.

In order to accelerate the hydrolysis and condensation reaction of each of the components in the preparation method, water or a mixed solution of water and alcohol is preferably added. Methanol and ethanol are preferred examples of the alcohol. If an organic solvent is used and this reaction is promoted by heating, the reaction is preferably performed at the reflux temperature of the organic solvent.

In cases where, for example, the organopolysiloxane having a condensed polycyclic aromatic group or a group containing a condensed polycyclic aromatic group contains an alkenyl group, the present composition is exemplified by a curable silicone composition comprising:
(A) an organopolysiloxane represented by the following average unit formula:

   (R¹¹₃SiO_{1/2})ₐ (R¹¹₂SiO_{2/2})_{b} (R²¹SiO_{3/2})_{c} (SiO_{4/2})_{d}

   wherein, R¹¹ are alkyl groups, alkenyl groups, or phenyl groups; R²¹ is a group recited for R¹¹, a condensed polycyclic aromatic group, or a group containing a condensed polycyclic aromatic group, provided that at least one of R¹¹ or R²¹ in a molecule is an alkenyl group, and at least one R²¹ in a molecule is a condensed polycyclic aromatic group or a group containing a condensed polycyclic aromatic group; and **a, b, c,** and **d** are numbers satisfying: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1;
(B) an organopolysiloxane having at least two silicon-bonded hydrogen atoms in a molecule; and
(C) a hydrosilylation reaction catalyst.

The organopolysiloxane of the component (A) is represented by the following average unit formula:

(R¹¹₃SiO_{1/2})ₐ (R¹¹₂SiO_{2/2})_{b} (R²¹SiO_{3/2})_{c} (SiO_{4/2})d.

In the formula, R¹¹ are alkyl groups, alkenyl groups, or phenyl groups. Examples of the alkyl group for R¹¹ include the same groups described for R¹. Of these, methyl groups are preferable. Examples of the alkenyl group for R¹¹ include the same groups described for R¹. Of these, vinyl groups are preferable.

Moreover, in the formula, R²¹ is the group represented by R¹¹, or is a condensed polycyclic aromatic group or a group containing a condensed polycyclic aromatic group. Examples of the alkyl group of R²¹ include the same groups described for R¹. Examples of the alkenyl group of R²¹ include the same groups described for R¹. Examples of the condensed polycyclic aromatic group of R²¹ include naphthyl groups, anthracenyl groups, phenanthryl groups, pyrenyl groups, and such condensed polycyclic aromatic groups where a hydrogen atom is replaced by an alkyl group such as a methyl group, an ethyl group, and the like; by an alkoxy group such as a methoxy group, an ethoxy group, and the like; or by a halogen atom such as a chlorine atom, a bromine atom, and the like. The condensed polycyclic aromatic groups for R²¹ are preferably naphthyl groups. Examples of the group containing a condensed polycyclic aromatic group for R²¹ include alkyl groups containing a condensed polycyclic aromatic group such as naphthyl ethyl groups, naphthyl propyl groups, anthracenyl ethyl groups, phenanthryl ethyl groups, pyrenyl ethyl groups, and the like; and such groups where a hydrogen atom in the condensed polycyclic aromatic group is replaced by an alkyl group such as a methyl group, an ethyl group, and the like; by an alkoxy group such as a methoxy group, an ethoxy group, and the like; or by a halogen atom such as a chlorine atom, a bromine atom, and the like. The groups containing a condensed polycyclic aromatic group for R²¹ are preferably alkyl groups containing a condensed polycyclic aromatic group, and particularly preferably naphthyl ethyl groups. An organopolysiloxane where R²¹ is an alkyl group containing a condensed polycyclic aromatic group has relatively low viscosity, and this organopolysiloxane has an effect to lower viscosity of the obtained curable silicone composition.

Furthermore, in the formula, at least one of R¹¹ or R²¹ in a molecule is an alkenyl group. Moreover, in the formula, at least one R²¹ in a molecule is a condensed polycyclic aromatic group or a group containing a condensed polycyclic aromatic group. Preferably, at least 50 mol% of R²¹ in a molecule are condensed polycyclic aromatic groups or groups containing a condensed polycyclic aromatic group.

Furthermore, in the formula, a, b, c, and d are numbers that satisfy: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1. Preferably, **a, b, c,** and **d** are numbers that satisfy: 0.05 ≤ **a** ≤ 0.7, 0 ≤ **b** ≤ 0.4, 0.3 ≤ **c** ≤ 0.9, 0 ≤ d < 0.2, and **a** + **b** + **c** + **d** = 1. Particularly preferably, **a, b, c,** and **d** are numbers that satisfy: 0.1 ≤ **a** ≤ 0.6, 0 ≤ **b** ≤ 0.3, 0.4 ≤ **c** ≤ 0.9, 0 ≤ **d** < 0.2, and **a** + **b** + **c** + **d** = 1. If **a** is less than the lower limit of the range described above, handling and processability of the obtained composition declines. On the other hand, transparency of the obtained cured product declines if **a** exceeds the upper limit of the range described above. Furthermore, stickiness of the obtained cured product occurs if b exceeds the upper limit of the range described above. Furthermore, refractive index of the obtained cured product may markedly decline if **c** is less than the lower limit of the range described above. On the other hand, the obtained cured product becomes excessively rigid and brittle if **c** exceeds the upper limit of the range described above. Furthermore, the obtained cured product becomes extremely rigid and brittle if d exceeds the upper limit of the range described above.

Although component (A) is represented by the above average unit formula, a small amount of the hydroxyl groups or methoxy groups, ethoxy groups, or the like alkoxy groups may be bonded to silicon atoms in the molecule. When component (A) contains silicon-bonded hydroxyl groups or silicon-bonded alkoxy groups, the adhesive properties of the obtained curable silicone composition, adhesion of a cured product thereof to a substrate, and affinity with other components contained in a curable silicone composition can be improved.

No particular limitation is placed on the organopolysiloxane for component (B) as long as the organopolysiloxane has a silicon-bonded hydrogen atom. Examples of the bond positions of the silicon-bonded hydrogen atoms in component (B) are molecular terminals and/or side molecular chains. The other groups bonded to the silicon atom in component (B) are exemplified by alkyl groups such as methyl groups, ethyl groups, propyl groups, butyl groups, pentyl groups, hexyl groups, heptyl groups, and the like; aryl groups such as phenyl groups, tolyl groups, xylyl groups, naphthyl groups, and the like; aralkyl groups such as benzyl groups, phenethyl groups, and the like; and halogenated alkyl groups such as chloromethyl groups, 3-chloropropyl groups, 3,3,3-trifluoropropyl groups, and the like; and such other groups are preferably methyl groups or phenyl groups. Component (B) may have a straight, branched, cyclic, net-like, or a partially branched straight chain molecular structure.

This type of organopolysiloxane for component (B) is exemplified by a methylhydrogenpolysiloxane capped at both molecular terminals with trimethylsiloxy groups, a copolymer of dimethylsiloxane and methylhydrogensiloxane capped at both molecular terminals with trimethylsiloxy groups, a copolymer of dimethylsiloxane, methylhydrogensiloxane, and methylphenylsiloxane capped at both molecular terminals with trimethylsiloxy groups, a dimethylpolysiloxane capped at both molecular terminals with dimethylhydrogensiloxy groups, a copolymer of dimethylsiloxane and methylphenylsiloxane capped at both molecular terminals with dimethylhydrogensiloxy groups, a methylphenylpolysiloxane capped at both molecular terminals with dimethylhydrogensiloxy groups, an organopolysiloxane copolymer composed of siloxane units represented by the general formula R'₃SiO_{1/2} and siloxane units represented by the general formula R'₂HSiO_{1/2} and siloxane units represented by the formula SiO_{4/2}, an organopolysiloxane copolymer composed of siloxane units represented by the general formula R'₂HSiO_{1/2} and siloxane units represented by the formula SiO_{4/2}, an organopolysiloxane copolymer composed of siloxane units represented by the general formula R'HSiO_{2/2} and siloxane units represented by the general formula R'SiO_{3/2} or siloxane units represented by the formula HSiO_{3/2}, and a mixture of two or more such organopolysiloxanes. Furthermore, R' in the formulae are alkyl groups such as methyl groups, ethyl groups, propyl groups, butyl groups, pentyl groups, hexyl groups, heptyl groups, and the like; aryl groups such as phenyl groups, tolyl groups, xylyl groups, naphthyl groups, and the like; aralkyl groups such as benzyl groups, phenethyl groups, and the like; or halogenated alkyl groups such as chloromethyl groups, 3-chloropropyl groups, 3,3,3-trifluoropropyl groups, and the like.

Examples of the hydrosilylation reaction catalyst for component (C) include platinum-based catalysts, rhodium-based catalysts, and palladium-based catalysts. Platinum-based catalysts are preferred due to the ability to remarkably promote curing of the present composition. Examples of the platinum-based catalyst include a platinum fine powder, chloroplatinic acid, an alcohol solution of chloroplatinic acid, a platinum-alkenylsiloxane complex, a platinum-olefin complex and a platinum-carbonyl complex, with a platinum-alkenylsiloxane complex being preferred.

In another composition of the present invention, for example, if the organopolysiloxane having a condensed polycyclic aromatic group or a group containing a condensed polycyclic aromatic group has a silicon-bonded hydrogen atom, the composition is exemplified by a curable silicone composition comprising:
(D) an organopolysiloxane represented by the following average unit formula:

   (R¹²₃SiO_{1/2})ₐ (R¹²₂SiO_{2/2})_{b} (R²²SiO_{3/2})_{c} (SiO_{4/2})_{d}

   wherein, R¹² are alkyl groups, phenyl groups, or hydrogen atoms; R²² is a group recited for R¹², a condensed polycyclic aromatic group, or a group containing a condensed polycyclic aromatic group, provided that at least one of R¹² or R²² in a molecule is a hydrogen atom, and at least one R²² in a molecule is a condensed polycyclic aromatic group or a group containing a condensed polycyclic aromatic group; and **a, b, c,** and **d** are numbers satisfying: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1;
(E) an organopolysiloxane having at least two alkenyl groups in a molecule; and
(C) a hydrosilylation reaction catalyst.

The organopolysiloxane for component (D) is represented by the following average unit formula:

(R¹²₃SiO_{1/2})ₐ (R¹²₂SiO_{2/2})_{b} (R²²SiO_{3/2})_{c} (SiO_{4/2})_{d}.

In the formula, R¹² are alkyl groups, phenyl groups, or hydrogen atoms. Examples of the alkyl group for R¹² include the same groups described for R¹. Of these, methyl groups are preferable.

Moreover, in the formula, R²² is represented by R¹² or a condensed polycyclic aromatic group or a group containing a condensed polycyclic aromatic group. Examples of the alkyl group for R²² include the same groups described for R¹. Examples of the condensed polycyclic aromatic group for R²² include naphthyl groups, anthracenyl groups, phenanthryl groups, pyrenyl groups, and such condensed polycyclic aromatic groups where a hydrogen atom is replaced by an alkyl group such as a methyl group, an ethyl group, and the like; by an alkoxy group such as a methoxy group, an ethoxy group, and the like; or by a halogen atom such as a chlorine atom, a bromine atom, and the like. The condensed polycyclic aromatic groups for R²² are preferably naphthyl groups. Examples of the group containing a condensed polycyclic aromatic group of R²² include alkyl groups containing condensed polycyclic aromatic groups such as naphthyl ethyl groups, naphthyl propyl groups, anthracenyl ethyl groups, phenanthryl ethyl groups, pyrenyl ethyl groups, and the like, and such groups where a hydrogen atom of the condensed polycyclic aromatic group is replaced by an alkyl group such as a methyl group, an ethyl group, and the like; an alkoxy group such as a methoxy group, an ethoxy group, and the like; or a halogen atom such as a chlorine atom, a bromine atom, and the like. Of these, alkyl groups containing a condensed polycyclic aromatic group are preferable, and naphthyl ethyl groups are particularly preferable. An organopolysiloxane where R²² is an alkyl group containing a condensed polycyclic aromatic group has relatively low viscosity, and this organopolysiloxane has an effect to lower viscosity of the obtained curable silicone composition.

Note that, in the formula, at least one of R¹² or R²² in a molecule is a hydrogen atom. Moreover, in the formula, at least one R²² in a molecule is a condensed polycyclic aromatic group or a group containing a condensed polycyclic aromatic group. Preferably, at least 50 mol% of R²² in a molecule are condensed polycyclic aromatic groups or groups containing a condensed polycyclic aromatic group.

Furthermore, in the formula, a, b, c, and d are numbers that satisfy: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1. Preferably, **a, b, c,** and **d** are numbers that satisfy: 0.05 ≤ **a** ≤ 0.7, 0 ≤ **b** ≤ 0.4, 0.3 ≤ **c** ≤ 0.9, 0 ≤ **d** < 0.2, and **a** + **b** + **c** + **d** = 1. Particularly preferably, **a, b, c,** and **d** are numbers that satisfy: 0.1 ≤ **a** ≤ 0.6, 0 ≤ **b** ≤ 0.3, 0.4 ≤ **c** ≤ 0.9, 0 ≤ **d** < 0.2, and **a** + **b** + **c** + **d** = 1. If **a** is less than the lower limit of the range described above, handling and processability of the obtained composition declines. On the other hand, transparency of the obtained cured product declines if **a** exceeds the upper limit of the range described above. Furthermore, stickiness of the obtained cured product occurs if **b** exceeds the upper limit of the range described above. Furthermore, refractive index of the obtained cured product may markedly decline if c is less than the lower limit of the range described above. On the other hand, the obtained cured product becomes excessively rigid and brittle if c exceeds the upper limit of the range described above. Furthermore, the obtained cured product becomes extremely rigid and brittle if d exceeds the upper limit of the range described above.

Although component (D) is represented by the above average unit formula, a small amount of the hydroxyl groups or methoxy groups, ethoxy groups, or the like alkoxy groups may be bonded to silicon atoms in the molecule. When component (D) contains silicon-bonded hydroxyl groups or silicon-bonded alkoxy groups, the adhesive properties of the obtained curable silicone composition, adhesion of a cured product thereof to a substrate, and affinity with other components contained in a curable silicone composition can be improved.

No particular limitation is placed on the organopolysiloxane for component (E) as long as it has an alkenyl group. Examples of the alkenyl group in component (E) include a vinyl group, an allyl group, a butenyl group, a pentenyl group, a hexenyl group, and a heptenyl group. Of these, a vinyl group is preferable. Non-alkenyl groups in component (E) bonding to the silicon atom are exemplified by alkyl groups such as methyl groups, ethyl groups, propyl groups, butyl groups, pentyl groups, hexyl groups, heptyl groups, and the like; aryl groups such as phenyl groups, tolyl groups, xylyl groups, naphthyl groups, and the like; aralkyl groups such as benzyl groups, phenethyl groups, and the like; and halogenated alkyl groups such as chloromethyl groups, 3-chloropropyl groups, 3,3,3-trifluoropropyl groups, and the like; and such non-alkenyl groups are preferably methyl groups or phenyl groups. Component (E) may have a straight, branched, cyclic, net-like, or a partially branched straight chain molecular structure.

This type of organopolysiloxane for component (E) is exemplified by a copolymer of dimethylsiloxane and methylvinylsiloxane capped at both molecular terminals with trimethylsiloxy groups, a methylvinylpolysiloxane capped at both molecular terminals with trimethylsiloxy groups, a copolymer of dimethylsiloxane, methylvinylsiloxane, and methylphenylsiloxane capped at both molecular terminals with trimethylsiloxy groups, a dimethylpolysiloxane capped at both molecular terminals with dimethylvinylsiloxy groups, a methylvinylpolysiloxane capped at both molecular terminals with dimethylvinylsiloxy groups, a copolymer of dimethylsiloxane and methylvinylsiloxane capped at both molecular terminals with dimethylvinylsiloxy groups, a copolymer of dimethylsiloxane, methylvinylsiloxane, and methylphenylsiloxane capped at both molecular terminals with dimethylvinylsiloxy groups, an organopolysiloxane copolymer composed of siloxane units represented by the general formula R'₃SiO_{1/2} and siloxane units represented by the general formula R'₂R"SiO_{1/2} and siloxane units represented by the formula SiO_{4/2}, an organopolysiloxane copolymer composed of siloxane units represented by the general formula R'₂R"SiO_{1/2} and siloxane units represented by the formula SiO_{4/2}, an organopolysiloxane copolymer composed of siloxane units represented by the general formula R'R"SiO_{2/2} and siloxane units represented by the formula R'SiO_{3/2} or siloxane units represented by the general formula R"SiO_{3/2}, and a mixture of two or more such organopolysiloxanes. Furthermore, R' in the formulae are synonymous with the groups described above. Furthermore, R" in the formulae are alkenyl groups and are exemplified by vinyl groups, allyl groups, butenyl groups, pentenyl groups, hexenyl groups, and heptenyl groups.

Examples of the hydrosilylation reaction catalyst include those described above.

A curable silicone composition comprising: component (A), component (D), and component (C) may be prepared. Component (A), component (D), and component (C) are as described above.

In the present composition, the content of the organopolysiloxane having silicon-bonded hydrogen atoms is not particularly limited, but the amount preferably results in a molar ratio of silicon-bonded hydrogen atoms relative to alkenyl groups in the composition being in a range of 0.1 to 5, and particularly preferably in a range of 0.5 to 2.

In the present composition, the content of component (C) is not particularly limited as long as the curing of the composition can be accelerated. Specifically, the content is preferably an amount such that the catalyst metal in component (C) is in a range of 0.01 to 500 ppm, even more preferably in a range of 0.01 to 100 ppm, and particularly preferably in a range of 0.01 to 50 ppm in weight units with respect to the above composition.

The present composition may also contain an adhesion-imparting agent for improving the adhesion of the composition. Preferred adhesion-imparting agents are organosilicon compounds having at least one alkoxy group bonded to a silicon atom in a molecule. This alkoxy group is exemplified by a methoxy group, an ethoxy group, a propoxy group, a butoxy group, and a methoxyethoxy group; and the methoxy group is particularly preferred. Moreover, non-alkoxy groups bonded to a silicon atom of this organosilicon compound are exemplified by substituted or unsubstituted monovalent hydrocarbon groups such as alkyl groups, alkenyl groups, aryl groups, aralkyl groups, halogenated alkyl groups and the like; epoxy group-containing monovalent organic groups such as glycidoxyalkyl groups (such as a 3-glycidoxypropyl group, a 4-glycidoxybutyl group, and the like), epoxycyclohexylalkyl groups (such as a 2-(3,4-epoxycyclohexyl)ethyl group, a 3-(3,4-epoxycyclohexyl)propyl group, and the like), oxiranylalkyl groups (such as a 4-oxiranylbutyl group, an 8-oxiranyloctyl group, and the like), and the like; acrylic group-containing monovalent organic groups such as a 3-methacryloxypropyl group and the like; and a hydrogen atom. This organosilicon compound preferably has a silicon-bonded alkenyl group or silicon-bonded hydrogen atom. Moreover, due to the ability to impart good adhesion with respect to various types of substrates, this organosilicon compound preferably has at least one epoxy group-containing monovalent organic group in a molecule. This type of organosilicon compound is exemplified by organosilane compounds, organosiloxane oligomers, and alkyl silicates. Molecular structure of the organosiloxane oligomer or alkyl silicate is exemplified by a straight structure, partially branched straight structure, branched chain structure, ring-shaped structure, and net-shaped structure. A straight chain structure, branched chain structure, and net-shaped structure are particularly preferred. This type of organosilicon compound is exemplified by silane compounds such as 3-glycidoxypropyltrimethoxysilane, 2-(3,4-epoxycyclohexyl)ethyltrimethoxysilane, 3-methacryloxy propyltrimethoxysilane, and the like; siloxane compounds having at least one of silicon-bonded alkenyl groups and silicon-bonded hydrogen atoms, and at least one silicon-bonded alkoxy group in a molecule; mixtures of a silane compound or siloxane compound having at least one silicon-bonded alkoxy group and a siloxane compound having at least one silicon-bonded hydroxyl group and at least one silicon-bonded alkenyl group in a molecule; and methyl polysilicate, ethyl polysilicate, and epoxy group-containing ethyl polysilicate.

In the present composition, the content of this adhesion-imparting agent is not particularly limited, but is preferably in a range of 0.01 to 10 parts by weight per total of 100 parts by weight of the composition.

A reaction inhibitor, for example, an alkyne alcohol such as 2-methyl-3-butyn-2-ol, 3,5-dimethyl-1-hexyn-3-ol, and 2-phenyl-3-butyn-2-ol; an ene-yne compound such as 3-methyl-3-penten-1-yne, and 3,5-dimethyl-3-hexen-1-yne; or 1,3,5,7-tetramethyl-1,3,5,7-tetravinylcyclotetrasiloxane, 1,3,5,7-tetramethyl-1,3,5,7-tetrahexenylcyclotetrasiloxane, or a benzotriazole may be incorporated as an optional component in the present composition.

In the present composition, the content of the reaction inhibitor is not limited, but is preferably from 0.0001 to 5 parts by weight per 100 parts by weight of the present composition.

This composition may also contain a fluorescent substance as an optional component. This fluorescent substance is exemplified by substances widely used in light emitting diodes (LEDs), such as yellow, red, green, and blue light-emitting fluorescent substances such as oxide fluorescent substances, oxynitride fluorescent substances, nitride fluorescent substances, sulfide fluorescent substances, oxysulfide fluorescent substances, and the like. Examples of oxide fluorescent substances include yttrium, aluminum, and garnet-type YAG green to yellow light-emitting fluorescent substances containing cerium ions; terbium, aluminum, and garnet-type TAG yellow light-emitting fluorescent substances containing cerium ions; and silicate green to yellow light-emitting fluorescent substances containing cerium or europium ions. Examples of oxynitride fluorescent substances include silicon, aluminum, oxygen, and nitrogen-type SiAlON red to green light-emitting fluorescent substances containing europium ions. Examples of nitride fluorescent substances include calcium, strontium, aluminum, silicon, and nitrogen-type CASN red light-emitting fluorescent substances containing europium ions. Examples of sulfide fluorescent substances include ZnS green light-emitting fluorescent substances containing copper ions or aluminum ions. Examples of oxysulfide fluorescent substances include Y₂O₂S red light-emitting fluorescent substances containing europium ions. These fluorescent substances may be used as one type or as a mixture of two or more types.

In this composition, the content of the fluorescent substances is not particularly limited but is in a range of 0.1 to 70 wt.% and is preferably in a range of 1 to 20 wt.% in the composition.

Moreover, an inorganic filler such as silica, glass, alumina or zinc oxide; an organic resin fine powder of a polymethacrylate resin and the like; a heat-resistant agent, a dye, a pigment, a flame retardant, a solvent and the like may be incorporated as optional components in the present composition at levels that do not impair the object of the present invention.

The present composition is such that curing occurs either at room temperature or under heating, but it is preferable to heat the composition in order to achieve rapid curing. The heating temperature is preferably from 50 to 200°C. Such a composition may be used as an adhesive, a potting agent, a protective agent, a coating agent, or an underfill agent for electrical/electronic use. In particular, the composition is particularly suitable as an adhesive, a potting agent, a protective agent, a coating agent, or an underfill agent, in a semiconductor element for optical applications due to the high optical transmittance of the composition.

The cured product of the present invention will now be described in detail.

The cured product of the present invention is formed by curing the curable silicone composition described above. The shape of the cured product of the present invention is not particularly limited, and examples include a sheet-shape, a film-shape, a convex lens shape, a concave lens shape, a Fresnel lens shape, a truncated cone shape, and a square cone platform. The cured product of the present invention can be handled alone or in a state in which it covers or seals an optical semiconductor element or the like.

The optical semiconductor device of the present invention will now be explained in detail.

This device is characterized in that an optical semiconductor element is covered or sealed by a cured product of the curable silicone composition described above. An example of this optical semiconductor element is a light emitting diode (LED) chip. Examples of such an optical semiconductor device include a light emitting diode (LED), a photocoupler, and a CCD.

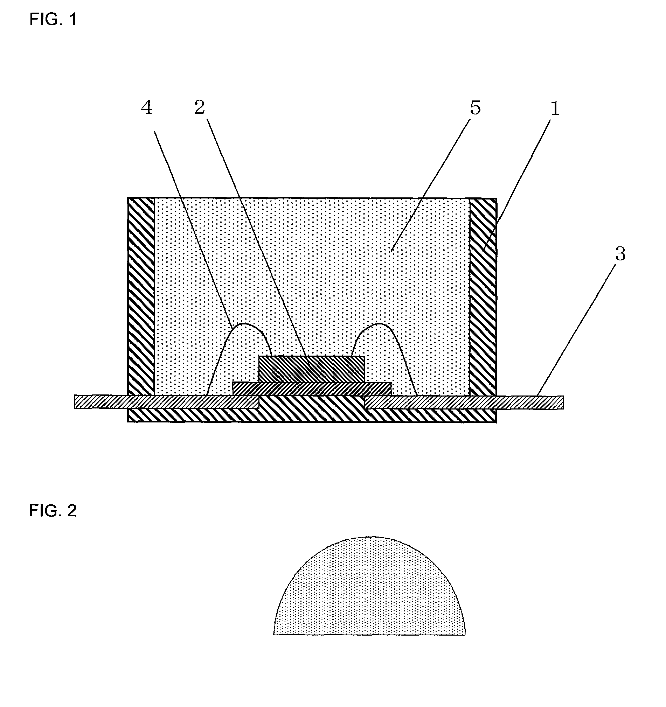

FIG. 1 illustrates a cross-sectional view of a single surface mounted type LED, which is one example of the optical semiconductor device of the present invention. In the LED illustrated in FIG. 1, an LED chip 1 is die-bonded to a lead frame 2, and the LED chip 1 and a lead frame 3 are wire-bonded by a bonding wire 4. This LED chip 1 is covered by a cured product 5 of the curable silicone composition of the present invention.

An example of a method of producing the surface mounted type LED illustrated in FIG. 1 is a method of die-bonding the LED chip 1 to the lead frame 2, wire-bonding the LED chip 1 and the lead frame 3 with a gold bonding wire 4, coating the LED chip 1 with the curable silicone composition of the present invention, and then curing the composition by heating at 50 to 200°C.

### Examples

The curable silicone composition, the cured product, and the optical semiconductor device of the present invention will be described in detail hereinafter using examples. The characteristics of the curable silicone composition and the cured product thereof were measured as follows, and the results are shown in Table 1.

### [Viscosity of the curable silicone composition]

The viscosity at 25°C of the curable silicone composition was measured using an AR 500 (manufactured by TA Instruments) with a cone having a cone diameter of 20 mm, and a cone angle of 2° at 20 s⁻¹.

### [Storage modulus of the cured product of the curable silicone composition]

The curable silicone composition was poured into a stainless-steel mold having a dimension of 2 mm x 10 mm x 50 mm, and heated for 10 minutes using a press heated at 150°C. Thereafter, the composition was removed from the mold, and heated in a circulating hot air oven at 150°C for 50 minutes to cure. The storage modulus at 25°C of the obtained cured product was measured using an MCR 301 Rheometer (manufactured by Anton Paar GmbH) under the following conditions: frequency: 1 Hz; and strain: 0.1 %.

### [Refractive index of the cured product]

The refractive index of the cured product formed with the method described above was measured using a prism coupler method. A 632.8 nm laser light source was used for the measurements.

### [Transparency of the cured product]

The transparency of the cured product formed with the method described above was confirmed visually.

### [Heat resistance of the cured product]

Presence or absence of the coloration of the cured product formed with the method described above was visually confirmed after heating the cured product in a circulating hot air oven at 150°C for 100 hours. The cured product having no coloration was evaluated as "excellent."

### [Water vapor permeability of the cured product]

The curable silicone composition was poured into a stainless-steel mold having a dimension of 1 mm x 15 mm x 20 mm, and heated for 10 minutes using a press heated at 150°C. Thereafter, the composition was removed from the mold, and heated in a circulating hot air oven at 150°C for 50 minutes to form a cured product having a thickness of 1 mm. In addition, the water vapor permeability of this cured product was measured in accordance with the method stipulated in JIS Z 0208 at a temperature of 40°C and a relative humidity of 90%.

### [Strain at breaking point and breaking energy of the cured product]

The curable silicone composition was cured by using a hot press at 150°C for 1 hour to produce a rectangular film having a thickness of 0.5 mm and a width of 5 mm. Then, the rectangular film was left for a day or longer at 25°C and a relative humidity of 50% to adjust the moisture, a tensile test was conducted using a Universal Tester (Autograph AGS-1 kNX, manufactured by Shimadzu Corporation), with a tensile speed of 15 mm/min and a distance between chucks of 25 mm. The strain at breaking point of a sample was calculated from an average value of the moved distances of the chucks measured for about five times. The breaking energy was also calculated from the area under the stress-strain curve.

### [Production of a surface mounted type light emitting diode (LED)]

The curable silicone composition was used to produce a surface-mounted type light emitting diode (LED) as described below. The results of the light extraction measurement of this light emitting diode (LED) were evaluated as follows, and the results are shown in Table 1.

An MKO4545C LED chip 2 measuring 1 mm x 1 mm on each side manufactured by Bridgelux, Inc. was mounted on a TTI-5074 LED lead frame measuring 5 mm × 5 mm on each side manufactured by I-Chiun Precision Industry Co., Ltd. enclosed peripherally by a polyphthalamide (PPA) resin case 1. Then, the LED chip 2 and an inner lead 3 were electrically connected by a gold bonding wire 4 with a thickness of 1.5 mil. In 3 g of the curable silicone composition, 0.105 g of terbium aluminum garnet phosphor (NTAG4851; manufactured by Intematix Corporation) was added and mixed. After degassing the mixture, 14.3 mg of the mixture was injected into the polyphthalamide (PPA) resin case 1 using a dispenser and cured by heating at 150°C for 1 hour to produce the surface mounted type light emitting diode (LED) illustrated in FIG. 1.

### [Light extraction measurement of the light emitting diode (LED)]

Light intensity of the surface mounted type light emitting diode (LED) produced by the method described above was measured using an ISP 250 (250 mm integrating sphere) and a CAS-140 CT spectrometer (both manufactured by Instrument Systems GmbH) by conducting a current of 150 mA to the LED using the Model 2600 SourceMeter (manufactured by Keithley Instruments Inc.).

Organopolysiloxanes used in practical examples are prepared as described below. In addition, the characteristics of the organopolysiloxane were evaluated as follows. Note that, in the average unit formulae, Me denotes a methyl group, Vi denotes a vinyl group, Ph denotes a phenyl group, Naph denotes a 1-naphthyl group, Naph-Et denotes a naphthyl ethyl group, and Ep denotes a 3-glycidoxypropyl group.

### [Weight average molecular weight and dispersity]

The weight average molecular weight (Mw) and number average molecular weight (Mn) in terms of standard polystyrene of the organopolysiloxane were determined by means of gel permeation chromatography using a UV detector. The dispersity (Mw/Mn) was determined from these values.

### [Refractive index]

The refractive index of the organopolysiloxane was measured at 25°C and a wavelength of 632.8 nm.

### [Reference Example 1]

10 g (40.3 mmol) of 1-naphthyltrimethoxysilane, 1.2 g (5.6 mmol) of methyidiphenyisilanol, 3.3 g (10.6 mmol) of 1,3-divinyl-1,3-diphenyldimethyldisiloxane and 20 g of toluene were placed in a reaction vessel and mixed, after which 2.2 g (122.1 mmol) of water and 10 g of methanol were added to the reaction vessel, 0.069 g (0.46 mmol) of trifluoromethane sulfonic acid was added to the reaction vessel under stirring, and heating to reflux was carried out for 2 hours. Thereafter, the mixture was distilled at atmospheric pressure by heating until a temperature of 85°C was reached. The mixture was reacted for 1 hour at this temperature. Thereafter, 0.06 g (1.1 mmol) of potassium hydroxide was added, and atmospheric pressure distillation was performed while heating to a reaction temperature of 120°C. The mixture was reacted for 1 hour at this temperature. The mixture was cooled to room temperature, and a neutralization reaction was performed by adding 0.07 g (1.2 mmol) of acetic acid. After the produced salt was filtered out, the low boiling point substances were removed from the resulting clear solution under reduced pressure while heating, and 10.0 g (yield: 85.5%) of a colorless, clear, gum-like viscous liquid was obtained.

As a result of NMR analysis, this liquid was found to be the organopolysiloxane represented by the following average unit formula:

(MePh₂SiO_{1/2})_{0.08} (MePhViSiO_{1/2})_{0.32} (NaphSiO_{3/2})_{0.60}.

The weight average molecular weight (Mw) of this organopolysiloxane was 1,000. The dispersity (Mw/Mn) was 1.11. The refractive index was 1.623.

### [Reference Example 2]

50 g (201.3 mmol) of 1-naphthyltrimethoxysilane, 20.9 g (67.3 mmol) of 1,3-divinyl-1,3-diphenyldimethyldisiloxane, and 100 g of toluene were placed in a reaction vessel and mixed, after which 12.0 g (666.1 mmol) of water and 50 g of methanol were added to the reaction vessel, 0.345 g (2.3 mmol) of trifluoromethane sulfonic acid was added to the reaction vessel under stirring, and heating to reflux was carried out for 2 hours. Thereafter, the mixture was distilled at atmospheric pressure by heating until a temperature of 85°C was reached. The mixture was reacted for 1 hour at this temperature. Thereafter, 0.30 g (5.4 mmol) of potassium hydroxide was added, and atmospheric pressure distillation was performed while heating to a reaction temperature of 120°C. The mixture was reacted for 1 hour at this temperature. The mixture was cooled to room temperature, and a neutralization reaction was performed by adding 0.40 g (6.7 mmol) of acetic acid. After the produced salt was filtered out, the low boiling point substances were removed from the resulting clear solution under reduced pressure while heating, and 56.7 g (yield: 99.3%) of a colorless, clear, viscous liquid with a viscosity exceeding 10,000 Pa•s was obtained.

As a result of NMR analysis, this viscous liquid was found to be the organopolysiloxane represented by the following average unit formula:

(MeViPhSiO_{1/2})_{0.40} (NaphSiO_{3/2})_{0.60}.

The weight average molecular weight (Mw) of this organopolysiloxane was 1,100. The dispersity (Mw/Mn) was 1.12. The refractive index was 1.622.

### [Reference Example 3]

50 g (201 mmol) of 1-naphthyltrimethoxysilane was placed in a reaction vessel and melted by being heated, after which 0.06 g (0.4 mmol) of trifluoromethane sulfonic acid was added to the reaction vessel. While the system was heated to 45 to 50°C, 9.3 g (154.9 mmol) of acetic acid was added in a drop-wise manner. After completion of drop-wise addition, the mixture was heated and stirred for 30 minutes at 50°C. The low boiling point substances were distilled at atmospheric pressure by heating until the reaction temperature reached 80°C. Thereafter, the mixture was cooled down to room temperature. 24.4 g (181.6 mmol) of 1,1,3,3-tetramethyldisiloxane was added in a drop-wise manner, and the mixture was heated to reach a reaction temperature of 45°C. Thereafter, 18 g of acetic acid was added drop-wise at 45 to 50°C. After completion of drop-wise addition, the mixture was heated and stirred for 30 minutes at 50°C. While the system was maintained at a temperature of 60°C or less by air or water cooling, 15.5 g (151.8 mmol) of acetic acid anhydride was added in a drop-wise manner. After completion of drop-wise addition, the mixture was heated and stirred for 30 minutes at 50°C. Thereafter, toluene and water were added, the mixture was stirred, and the mixture was allowed to sit. The water washing was performed while repeatedly removing the lower layer. After confirming that pH of the lower layer was 7, the upper layer (i.e. toluene layer) was heated and distilled under reduced pressure to remove low boiling point substances. 43 g (yield: 76.0%) of colorless clear liquid was obtained.

As a result of NMR analysis, this liquid was found to be the organopolysiloxane represented by the following average unit formula:

(HMe₂SiO_{1/2})_{0.59} (NaphSiO_{3/2})_{0.41}.

The weight average molecular weight (Mw) of this organopolysiloxane was 660. The dispersity (Mw/Mn) was 1.05. The refractive index was 1.548.

### [Reference Example 4]

148.8 g (0.6 mol) of 1-naphthyltrimethoxysilane and 37.2 g (0.2 mol) of 1,3-divinyltetramethyldisiloxane were placed in a reaction vessel and mixed, after which 0.136 g (0.9 mmol) of trifluoromethane sulfonic acid was added, 35.6 g (1.98 mol) of water was added under stirring, and the mixture was heated to reflux for 2 hours. Next, the mixture was distilled at atmospheric pressure by heating until the temperature reached 85°C. Next, 62.0 g of toluene and 0.194 g (3.5 mmol) of potassium hydroxide were added, and the mixture was distilled at atmospheric pressure by heating until the reaction temperature reached 120°C and then allowed to react at this temperature for 6 hours. The mixture was then cooled to room temperature, and a neutralization reaction was performed by adding 0.21 g (3.5 mmol) of acetic acid. After the produced salt was filtered out, the low boiling point substances were removed from the resulting clear solution under reduced pressure while heating, and 130.0 g (yield: 89.9%) of a colorless, clear, gum-like viscous liquid was obtained.

As a result of NMR analysis, this liquid was found to be the organopolysiloxane represented by the following average unit formula:

(Me₂ViSiO_{1/2})_{0.40} (NaphSiO_{3/2})_{0.60}.

The weight average molecular weight (Mw) of this organopolysiloxane was 1,000. The dispersity (Mw/Mn) was 1.03. The refractive index was 1.603.

### [Reference Example 5]

24.84 g (90 mmol) of 2-(trimethoxysilylethyl)naphthalene, 5.58 g (30 mmol) of 1 ,3-divinyltetramethyldisiloxane, and 10.4 g of toluene were placed in a reaction vessel and mixed, after which 0.072 g (0.48 mmol) of trifluoromethane sulfonic acid was added to the reaction vessel, 5.35 g (297 mmol) of water was added to the reaction vessel under stirring, and heating to reflux was carried out for 2 hours. Next, the mixture was distilled at atmospheric pressure by heating until the temperature reached 85°C. Thereafter, 0.068 g (1.21 mmol) of potassium hydroxide was added, and atmospheric pressure distillation was performed while heating to a reaction temperature of 120°C. The mixture was reacted for 6 hours at this temperature. The mixture was then cooled to room temperature, and a neutralization reaction was performed by adding 0.072 g (1.21 mmol) of acetic acid. After the produced salt was filtered out, low boiling point substances were removed from the resulting clear solution under reduced pressure while heating, and 20.12 g (yield: 83%) of a clear liquid having a viscosity of 137 Pa•s was obtained.

As a result of NMR analysis, this liquid was found to be the organopolysiloxane represented by the following average unit formula:

(Me₂ViSiO_{1/2})_{0.40} (Naph-EtSiO_{3/2})_{0.60}.

The weight average molecular weight (Mw) of this organopolysiloxane was 2,000. The dispersity (Mw/Mn) was 1.09. The refractive index was 1.594.

### [Practical Example 1]

4.01 g of the organopolysiloxane prepared in Reference Example 1 and represented by the following average unit formula:

(MePh₂SiO_{1/2})_{0.08} (MePhViSiO_{1/2})_{0.32} (NaphSiO_{3/2})_{0.60},

1.77 g of an organopolysiloxane represented by the following average formula:

HMe₂SiO(Ph₂SiO)_{2.5}SiMe₂H,

0.33 g of the organopolysiloxane prepared in Reference Example 3 and represented by the following average unit formula:

(HMe₂SiO_{1/2})_{0.59} (NaphSiO_{3/2})_{0.41},

0.038 g of a cyclic methylvinyl siloxane, and a 1,3-divinyltetramethyldisiloxane solution of a platinum-1 ,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 790 MPa. In addition, this cured product had a refractive index of 1.609 at a wavelength of 632.8 nm. This cured product was aged in an oven at 150°C for 100 hours, but no change in color was observed.

### [Practical Example 2]

12 g of the organopolysiloxane prepared in Reference Example 2 and represented by the following average unit formula:

(MeViPhSiO_{1/2})_{0.40} (NaphSiO_{3/2})_{0.60},

5.34 g of an organopolysiloxane represented by the following average formula:

HMe₂SiO(Ph₂SiO)_{2.5}SiMe₂H,

1.8 g of the organopolysiloxane prepared in Reference Example 3 and represented by the following average unit formula:

(HMe₂SiO_{1/2})_{0.59} (NaphSiO_{3/2})_{0.41},

0.06 g of a cyclic methylvinylsiloxane, and a 1 ,3-divinyltetramethyldisiloxane solution of a platinum-1 ,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 950 MPa. In addition, this cured product had a refractive index of 1.606 at a wavelength of 632.8 nm. This cured product was aged in an oven at 150°C for 100 hours, but no change in color was observed. In addition, the water vapor permeability of this cured product was measured in accordance with the method stipulated in JIS Z 0208 at a thickness of 1 mm, a temperature of 40°C and a relative humidity of 90%, and found to be 2.4 g/m²•24hr.

In 3 g of this curable silicone composition, 0.105 g of the phosphor (NTAG4851; manufactured by Intematix Corporation) was uniformly dispersed to prepare a curable silicone composition containing a fluorescent substance. The light extraction efficiency of an LED device using this curable silicone composition was 30.1 lumen.

### [Practical Example 3]

12 g of the organopolysiloxane prepared in Reference Example 1 and represented by the following average unit formula:

(MePh₂SiOi_{1/2})_{0.08} (MePhViSiO_{1/2})_{0.32} (NaphSiO_{3/2})_{0.60},

2.85 g of an organopolysiloxane represented by the following average formula:

HMe₂SiO(Ph₂SiO)SiMe₂H,

0.9 g of the organopolysiloxane prepared in Reference Example 3 and represented by the following average unit formula:

(HMe₂SiO_{1/2})_{0.59} (NaphSiO_{3/2})_{0.41},

0.06 g of a cyclic methylvinylsiloxane, and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 970 MPa. In addition, this cured product had a refractive index of 1.608 at a wavelength of 632.8 nm. This cured product was aged in an oven at 150°C for 100 hours, but no change in color was observed.

### [Practical Example 4]

12 g of the organopolysiloxane prepared in Reference Example 2 and represented by the following average unit formula:

(MeViPhSiO_{1/2})_{0.40} (NaphSiO_{3/2})_{0.60},

8.4 g of an organopolysiloxane represented by the following average formula:

HMe₂SiO(Ph₂SiO)_{2.5}SiMe₂H,

0.075 g of a cyclic methylvinylsiloxane, and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 660 MPa. In addition, this cured product had a refractive index of 1.606 at a wavelength of 632.8 nm. This cured product was aged in an oven at 150°C for 100 hours, but no change in color was observed.

In 3 g of this curable silicone composition, 0.105 g of the phosphor (NTAG4851; manufactured by Intematix Corporation) was uniformly dispersed to prepare a curable silicone composition containing a fluorescent substance. The light extraction efficiency of an LED device using this curable silicone composition was 30.9 lumen.

### [Practical Example 5]

5 g of the organopolysiloxane prepared in Reference Example 2 and represented by the following average unit formula:

(MeViPhSiO_{1/2})_{0.40} (NaphSiO_{3/2})_{0.60},

2 g of the organopolysiloxane prepared in Reference Example 3 and represented by the following average unit formula:

(HMe₂SiO_{1/2})_{0.59} (NaphSiO_{3/2})_{0.41},

0.03 g of a cyclic methylvinylsiloxane, and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 1,000 MPa. In addition, this cured product had a refractive index of 1.607 at a wavelength of 632.8 nm. This cured product was aged in an oven at 150°C for 100 hours, but no change in color was observed.

### [Practical Example 6]

5 g of the organopolysiloxane prepared in Reference Example 2 and represented by the following average unit formula:

(MeViPhSiO_{1/2})_{0.40} (NaphSiO_{3/2})_{0.60},

1 g of an organopolysiloxane represented by the following average formula:

ViMe₂SiO(MePhSiO)₂₅SiMe₂Vi,

0.5 g of an organopolysiloxane represented by the following average formula:

HMe₂SiO(Ph₂SiO)_{2.5}SiMe₂H,

1.5 g of the organopolysiloxane prepared in Reference Example 3 and represented by the following average unit formula:

(HMe₂SiO_{1/2})_{0.59} (NaphSiO_{3/2})_{0.41},

0.04 g of an organopolysiloxane represented by the following average unit formula: (EpSiO_{3/2})_{0.3} (ViMeSiO_{1/2})_{0.3} (Me₂SiO_{1/2})_{0.3} (MeO_{1/2})_{0.2},
0.03 g of a cyclic methylvinylsiloxane, and a 1,3-divinyltetramethyldisiloxane solution of a platinum-1 ,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 650 MPa. In addition, this cured product had a refractive index of 1.602 at a wavelength of 632.8 nm. This cured product was aged in an oven at 150°C for 100 hours, but no change in color was observed.

### [Practical Example 7]

5 g of the organopolysiloxane prepared in Reference Example 2 and represented by the following average unit formula:

(MeViPhSiO_{1/2})_{0.40} (NaphSiO_{3/2})_{0.60},

1 g of an organopolysiloxane represented by the following average formula:

ViMe₂Si0(MePhSiO)₂₅SiMe₂Vi,

2 g of the organopolysiloxane prepared in Reference Example 3 and represented by the following average unit formula:

(HMe₂SiO_{1/2})_{0.59} (NaphSiO_{3/2})_{0.41},

0.03 g of a cyclic methylvinylsiloxane, and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 890 MPa. In addition, this cured product had a refractive index of 1.604 at a wavelength of 632.8 nm. This cured product was aged in an oven at 150°C for 100 hours, but no change in color was observed.

### [Practical Example 8]

5 g of the organopolysiloxane prepared in Reference Example 2 and represented by the following average unit formula:

(MeViPhSiO_{1/2})_{0.40} (NaphSiO_{3/2})_{0.60},

0.5 g of an organopolysiloxane represented by the following average formula:

ViMe₂SiO(MePhSiO)₂₅SiMe₂Vi,

3 g of an organopolysiloxane represented by the following average formula:

HMe₂SiO(Ph₂SiO)₂₅SiMe₂H,

0.03 g of a cyclic methylvinylsiloxane, and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 260 MPa. In addition, this cured product had a refractive index of 1.600 at a wavelength of 632.8 nm. This cured product was aged in an oven at 150°C for 100 hours, but no change in color was observed.

### [Practical Example 9]

9 g of an organopolysiloxane represented by the following average formula:

ViMe₂SiO(MePhSiO)₂₅SiMe₂Vi,

1.02 g of the organopolysiloxane prepared in Reference Example 3 and represented by the following average unit formula:

(HMe₂SiO_{1/2})_{0.59} (NaphSiO_{3/2})_{0.41},

0.06 g of a cyclic methylvinylsiloxane, and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 0.24 MPa. In addition, this cured product had a refractive index of 1.547 at a wavelength of 632.8 nm. This cured product was aged in an oven at 150°C for 100 hours, but no change in color was observed.

### [Practical Example 10]

5.76 g of an organopolysiloxane represented by the following average unit formula:

(Me₂ViSiOₗ₁₂)_{0.25} (PhSiO_{3/2})_{0.75},

2 g of an organopolysiloxane represented by the following average formula:

HMe₂SiO(Ph₂SiO)SiMe₂H,

0.24 g of an organopolysiloxane represented by the following average unit formula:

(HMe₂SiO_{1/2})_{0.60} (PhSiO_{3/2})_{0.40},

0.5 g of the organopolysiloxane prepared in Reference Example 3 and represented by the following average unit formula:

(HMe₂SiO_{1/2})_{0.59}(NaphSiO_{3/2})_{0.41},

0.06 g of a cyclic methylvinylsiloxane, and a 1,3-divinyltetramethyldisiloxane solution of a platinum-1 ,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 84 MPa. In addition, this cured product had a refractive index of 1.547 at a wavelength of 632.8 nm. This cured product was aged in an oven at 150°C for 100 hours, but no change in color was observed.

### [Practical Example 11]

2.06 g of the organopolysiloxane prepared in Reference Example 2 and represented by the following average unit formula:

(MeViPhSiO_{1/2})_{0.40} (NaphSiO_{3/2})_{0.60},

7.13 g of an organopolysiloxane represented by the following average unit formula:

(Me₂ViSiO_{1/2})_{0.25}(PhSiO_{3/2})_{0.75},

0.3 g of an organopolysiloxane represented by the following average formula:

HMe₂SiO(Ph₂SiO)SiMe₂H,

2.48 g of the organopolysiloxane represented by the following average unit formula:

(HMe₂SiO_{1/2})_{0.60} (PhSiO_{3/2})_{0.40},

0.06 g of a cyclic methylvinylsiloxane, and a 1 ,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 540 MPa. In addition, this cured product had a refractive index of 1.560 at a wavelength of 632.8 nm. This cured product was aged in an oven at 150°C for 100 hours, but no change in color was observed.

### [Comparative Example 1]

4.9 g of an organopolysiloxane represented by the following average unit formula:

(Me₂ViSiO_{1/2})_{0.25} (PhSiO_{3/2})_{0.75},

0.65 g of an organopolysiloxane represented by the following average unit formula:

(Me₂ViSiO_{1/2})_{0.10} (Me₃SiO_{1/2})_{0.15} (PhSiO_{3/2})_{0.75},

1.5 g of an organopolysiloxane represented by the following average formula:

HMe₂SiO(Ph₂SiO)SiMe₂H,

0.16 g of an organopolysiloxane represented by the following average unit formula:

(HMe₂SiO_{1/2})_{0.60} (PhSiO_{3/2})_{0.40},

0.02 g of a cyclic methylvinylsiloxane, and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 45 MPa. In addition, this cured product had a refractive index of 1.548 at a wavelength of 632.8 nm. This cured product was aged in an oven at 150°C for 100 hours, but no change in color was observed. In addition, the water vapor permeability of this cured product was measured in accordance with the method stipulated in JIS Z 0208 at a thickness of 1 mm, a temperature of 40°C and a relative humidity of 90%, and found to be 15 g/m²•24hr.

In 3 g of this curable silicone composition, 0.105 g of the phosphor (NTAG4851; manufactured by Intematix Corporation) was uniformly dispersed to prepare a curable silicone composition containing a fluorescent substance. The light extraction efficiency of an LED device using this curable silicone composition was 29.7 lumen.

### [Comparative Example 2]

6.06 g of an organopolysiloxane represented by the following average formula:

Me₂ViSiO(Me₂SiO)ₓSiMe₂Vi,

(in the formula, x is a value such that the viscosity is 2,000 mPa•s),
3.5 g of an organopolysiloxane represented by the following average unit formula:

(Me₂ViSiO_{1/2})_{0.02} (Me₃SiO_{1/2})_{0.43} (SiO_{4/2})_{0.55},

0.24 g of an organopolysiloxane represented by the following average formula:

Me₃SiO(MeHSiO)₅₀SiMe₃,

0.5 g of an organopolysiloxane represented by the following average unit formula:

(EpSiO_{3/2})_{0.3} (ViMeSiO_{1/2})_{0.3} (Me₂SiO_{1/2})_{0.3} (MeO_{1/2})_{0.2},

and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition.

This curable silicone composition was coated on a quartz glass plate and cured by being heated for 1 hour at 150°C. The obtained cured product was clear and colorless and had a storage modulus at 25°C of 0.74 MPa. In addition, this cured product had a refractive index of 1.411 at a wavelength of 632.8 nm. This cured product was aged in an oven at 150°C for 100 hours, but no change in color was observed. In addition, the water vapor permeability of this cured product was measured in accordance with the method stipulated in JIS Z 0208 at a thickness of 1 mm, a temperature of 40°C and a relative humidity of 90%, and found to be 104 g/m²•24hr.

In 3 g of this curable silicone composition, 0.105 g of the phosphor (NTAG4851; manufactured by Intematix Corporation) was uniformly dispersed to prepare a curable silicone composition containing a fluorescent substance. The light extraction efficiency of an LED device using this curable silicone composition was 27.7 lumen.

### [Practical Example 12]

54.0 g of the organopolysiloxane prepared in Reference Example 4 and represented by the following average unit formula:

(Me₂ViSiO_{1/2})_{0.40} (NaphSiO_{3/2})_{0.60},

46.0 g of an organopolysiloxane represented by the following average formula:

HMe₂SiO(Ph₂SiO)_{2.5}SiMe₂H,

and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition having a viscosity of 33 Pa•s.

This curable silicone composition was coated on a quartz glass plate and cured by being heated for 1 hour at 150°C. The obtained cured product was clear and colorless and had a refractive index of 1.591 at a wavelength of 632.8 nm. The strain at breaking point of the cured product was 82%, and the breaking energy of the cured product was 0.3507 J. This cured product was aged in an oven at 150°C for 100 hours, but no change in color was observed.

### [Comparative Example 3]

60.5 g of an organopolysiloxane represented by the following average unit formula:

(Me₂ViSiO_{1/2})_{0.25} (PhSiO_{3/2})_{0.75},

30.5 g of an organopolysiloxane represented by the following average formula:

HMe₂SiO(Ph₂SiO)_{2.5}SiMe₂H,

and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition having a viscosity of 11 Pa•s.

This curable silicone composition was coated on a quartz glass plate and cured by being heated for 1 hour at 150°C. The obtained cured product was clear and colorless and had a refractive index of 1.559 at a wavelength of 632.8 nm. The strain at breaking point of the cured product was 41 %, and the breaking energy of the cured product was 0.2127 J. From these results, compared to the cured product of the curable silicone composition of Practical Example 12, the obtained cured product of the curable silicone composition of Comparative Example 3 showed less elongation, a lower breaking strength, and a lower refractive index. This cured product was aged in an oven at 150°C for 100 hours, but no change in color was observed.

### [Practical Example 13]

41.5 g of the organopolysiloxane prepared in Reference Example 4 and represented by the following average unit formula:

(Me₂ViSiO_{1/2})_{0.40} (NaphSiO_{3/2})_{0.60},

20.0 g of an organopolysiloxane represented by the following average formula:

ViMe₂SiO(MePhSiO)₂₅SiMe₂Vi,

38.5 g of an organopolysiloxane represented by the following average formula:

HMe₂SiO(Ph₂SiO)_{2.5}SiMe₂H,

and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition having a viscosity of 12 Pa•s.

This curable silicone composition was coated on a quartz glass plate and cured by being heated for 1 hour at 150°C. The obtained cured product was clear and colorless and had a refractive index of 1.580 at a wavelength of 632.8 nm. The strain at breaking point of the cured product was 191%, and the breaking energy of the cured product was 0.1389 J. This cured product was aged in an oven at 150°C for 100 hours, but no change in color was observed.

### [Practical Example 14]

23.0 g of the organopolysiloxane prepared in Reference Example 4 and represented by the following average unit formula:

(Me₂ViSiO_{1/2})_{0.40} (NaphSiO_{3/2})_{0.60},

20.5 g of an organopolysiloxane represented by the following average unit formula:

(Me₂ViSiO_{1/2})_{0.25} (PhSiO_{3/2})_{0.75},

20.0 g of an organopolysiloxane represented by the following average formula:

ViMe₂SiO(MePhSiO)₂₅SiMe₂Vi,

36.5 g of an organopolysiloxane represented by the following average formula:

HMe₂SiO(Ph₂SiO)_{2.5}SiMe₂H,

and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition having a viscosity of 9 Pa•s.

This curable silicone composition was coated on a quartz glass plate and cured by being heated for 1 hour at 150°C. The obtained cured product was clear and colorless and had a refractive index of 1.569 at a wavelength of 632.8 nm. The strain at breaking point of the cured product was 139%, and the breaking energy of the cured product was 0.0562 J. This cured product was aged in an oven at 150°C for 100 hours, but no change in color was observed.

### [Comparative Example 4]

46.3 g of an organopolysiloxane represented by the following average unit formula:

(Me₂ViSiO_{1/2})_{0.25} (PhSiO_{3/2})_{0.75},

20.0 g of an organopolysiloxane represented by the following average formula:

ViMe₂SiO(MePhSiO)₂₅SiMe₂Vi,

33.7 g of an organopolysiloxane represented by the following average formula:

HMe₂SiO(Ph₂SiO)_{2.5}SiMe₂H,

and a 1 ,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition having a viscosity of 6 Pa•s.

This curable silicone composition was coated on a quartz glass plate and cured by being heated for 1 hour at 150°C. The obtained cured product was clear and colorless and had a refractive index of 1.556 at a wavelength of 632.8 nm. The strain at breaking point of the cured product was 112%, and the breaking energy of the cured product was 0.0502 J. This cured product was aged in an oven at 150°C for 100 hours, but no change in color was observed.

Compared to the results of Practical Examples 13 and 14, the results of Comparative Example 4 showed less elongation, a lower breaking strength, and a lower refractive index.

### [Practical Example 15]

56.0 g of the organopolysiloxane prepared in Reference Example 5 and represented by the following average unit formula:

(Me₂ViSiO_{1/2})_{0.40} (Naph-EtSiO_{3/2})_{0.60},

44.0 g of an organopolysiloxane represented by the following average formula:

HMe₂SiO(Ph₂SiO)_{2.5}SiMe₂H,

and a 1 ,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition having a viscosity of 3 Pa•s.

This curable silicone composition was coated on a quartz glass plate and cured by being heated for 1 hour at 150°C. The obtained cured product was clear and colorless and had a refractive index of 1.582 at a wavelength of 632.8 nm. This cured product was aged in an oven at 150°C for 100 hours, but no change in color was observed.

### [Practical Example 16]

8 g of the organopolysiloxane prepared in Reference Example 4 and represented by the following average unit formula:

(MeViPhSiO_{1/2})_{0.40} (NaphSiO_{3/2})_{0.60},

1.6 g of an organopolysiloxane represented by the following average formula:

ViMe₂SiO(MePhSiO)₂₅SiMe₂Vi,

3.2 g of the organopolysiloxane prepared in Reference Example 3 and represented by the following average unit formula:

(HMe₂SiO_{1/2})_{0.59} (NaphSiO_{3/2})_{0.41},

0.08 g of an organopolysiloxane represented by the following average unit formula:

(EpSiO_{3/2})_{0.3} (ViMeSiO_{1/2})_{0.3} (Me₂SiO_{1/2})_{0.3} (MeO_{1/2})_{0.2},

0.06 g of a cyclic methylvinylsiloxane, and a 1,3-divinyltetramethyldisiloxane solution of a platinum-1,3-divinyltetramethyldisiloxane complex (used in the composition in such an amount that, in terms of weight units, the content of the platinum was 2 ppm) were homogeneously mixed so as to produce a curable silicone composition.

A glass epoxy substrate was disposed on the top mold of the compression molding machine. Next, a release film made of a tetrafluoroethylene resin disposed on the lower mold was hermetically attached to the lower mold by air suction. After 1.4 mL of a prepared sample was applied to the release film, the upper and lower molds were aligned. Compression molding was then performed for 5 minutes while applying a load of 3 MPa at 130°C in a state in which the substrate was sandwiched between the upper and lower molds. Thereafter, the substrate was removed from the molds, and further heat treated for 1 hour in an oven at 150°C to produce a lens illustrated in FIG. 2 on the substrate.

### Industrial Applicability

The curable silicone composition of the present invention is cured by a hydrosilylation reaction to form a cured product with a high refractive index, high transparency, and excellent heat resistance and flexibility, and especially a cured product having a low water vapor permeability. Therefore, the curable silicone composition can be used as an adhesive, a potting agent, a protective coating agent, or an underfill agent for electrical/electronic use. In particular, the optical transmittance is high, which makes the curable silicone composition suitable as a sealing agent or a covering agent for an LED element or as a lens forming material.

### Reference Numerals

1: Polyphthalamide (PPA) resin case
2: LED chip
3: Inner lead
4: Bonding wire
5: Cured product of the curable silicone composition

## Claims

1. A hydrosilylation curable silicone composition comprising, as a main component, an organopolysiloxane represented by an average unit formula:
(R¹₃SiO_{1/2})ₐ(R¹₂SiO_{2/2})_{b}(R²SiO_{3/2})_{c}(SiO_{4/2})_{d}
wherein, R¹ are alkyl groups, alkenyl groups, phenyl groups, or hydrogen atoms; R² is a group recited for R¹, a condensed polycyclic aromatic group, or a group containing a condensed polycyclic aromatic group, provided that at least one of R¹ or R² in a molecule is an alkenyl group or hydrogen atom, and at least one R² in a molecule is a condensed polycyclic aromatic group or a group containing a condensed polycyclic aromatic group; and **a, b, c,** and **d** are numbers satisfying: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1.

2. The curable silicone composition according to claim 1, wherein at least 50 mol% of R² in a molecule are condensed polycyclic aromatic groups or groups containing condensed polycyclic aromatic groups.

3. The curable silicone composition according to claim 1 or 2, wherein the condensed polycyclic aromatic group is a naphthyl group.

4. A curable silicone composition comprising at least:
(A) an organopolysiloxane represented by the following average unit formula:
(R¹¹₃SiO_{1/2})ₐ (R¹¹₂SiO_{2/2})_{b} (R²¹SiO_{3/2})_{c} (SiO_{4/2})_{d}
wherein, R¹¹ are alkyl groups, alkenyl groups, or phenyl groups; R²¹ is a group recited for R¹¹, a condensed polycyclic aromatic group, or a group containing a condensed polycyclic aromatic group, provided that at least one of R¹¹ or R²¹ in a molecule is an alkenyl group, and at least one R²¹ in a molecule is a condensed polycyclic aromatic group or a group containing a condensed polycyclic aromatic group; and **a, b, c,** and **d** are numbers satisfying: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1;
(B) an organopolysiloxane having at least two silicon-bonded hydrogen atoms in a molecule; and
(C) a hydrosilylation reaction catalyst.

5. A curable silicone composition comprising at least:
(D) an organopolysiloxane represented by the following average unit formula:
(R¹²₃SiO_{1/2})ₐ (R¹²₂SiO_{2/2})_{b} (R²²SiO_{3/2})_{c} (SiO_{4/2})_{d}
wherein, R¹² are alkyl groups, phenyl groups, or hydrogen atoms; R²² is a group recited for R¹², a condensed polycyclic aromatic group, or a group containing a condensed polycyclic aromatic group, provided that at least one of R¹² or R²² in a molecule is a hydrogen atom, and at least one R²² in a molecule is a condensed polycyclic aromatic group or a group containing a condensed polycyclic aromatic group; and **a, b, c,** and **d** are numbers satisfying: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1;
(E) an organopolysiloxane having at least two alkenyl groups in a molecule; and
(C) a hydrosilylation reaction catalyst.

6. A curable silicone composition comprising at least:
(A) an organopolysiloxane represented by the following average unit formula:
(R¹¹₃SiO_{1/2})ₐ(R¹¹₂SiO_{2/2})_{b}(R²¹SiO_{3/2})_{c}(SiO_{4/2})_{d}
wherein, R¹¹ are alkyl groups, alkenyl groups, or phenyl groups; R²¹ is a group recited for R¹¹, a condensed polycyclic aromatic group, or a group containing a condensed polycyclic aromatic group, provided that at least one of R¹¹ or R²¹ in a molecule is an alkenyl group, and at least one R²¹ in a molecule is a condensed polycyclic aromatic group or a group containing a condensed polycyclic aromatic group; and **a, b, c,** and **d** are numbers satisfying: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1;
(D) an organopolysiloxane represented by the following average unit formula:
(R¹²₃SiO_{1/2})ₐ (R¹²₂SiO_{2/2})_{b} (R²²SiO_{3/2})_{c} (SiO_{4/2})_{d}
wherein, R¹² are alkyl groups, phenyl groups, or hydrogen atoms; R²² is a group recited for R¹², a condensed polycyclic aromatic group, or a group containing a condensed polycyclic aromatic group, provided that at least one of R¹² or R²² in a molecule is a hydrogen atom, and at least one R²² in a molecule is a condensed polycyclic aromatic group or a group containing a condensed polycyclic aromatic group; and **a, b, c,** and **d** are numbers satisfying: 0.01 ≤ **a** ≤ 0.8, 0 ≤ **b** ≤ 0.5, 0.2 ≤ **c** ≤ 0.9, 0 ≤ **d** < 0.2, and **a** + **b** + **c** + **d** = 1; and
(C) a hydrosilylation reaction catalyst.

7. The curable silicone composition according to any one of claims 1 to 6, further comprising a fluorescent substance.

8. A cured product produced by curing the curable silicone composition described in any one of claims 1 to 7.

9. An optical semiconductor device formed by covering or sealing an optical semiconductor element with the curable silicone composition described in any one of claims 1 to 7.
